# EUROPEAN PATENT APPLICATION

(11) **EP 0 525 256 A1**
(43) Date of publication of application: **03.02.1993**
(21) Application number: 91306797.1
(22) Date of filing: 25.07.1991
(51) Int. Cl.: H01L 21/76, H01L 21/74

(54) **Method of fabricating isolated device regions**

(71) Applicant: MOTOROLA, INC., Schaumburg, IL 60196 (US)
(72) Inventor: Cambou, Bertrand F., Mesa, Arizona 85202 (US)
(74) Representative: Lupton, Frederick

(57) **Abstract**

A method of fabricating isolated device regions (24,16) includes providing a first semiconductor substrate (12) having a dielectric layer (16) disposed on a first surface (14) thereof. A second semiconductor substrate (18) is bonded to the dielectric layer (16) and etched back to a desired thickness. A buried layer (20) is formed in the second substrate (18) following the etch back and a thin epitaxial layer (22) is then formed on the second substrate (18). Isolation trenches (28) are formed through the epitaxial layer (22) and the second substrate (28) and extend to the dielectric layer (16). The isolation trenches (28) are filled with dielectric material to isolate regions (24,26) therebetween.

## Description

### Background of the Invention

This invention relates, in general, to semiconductor devices, and more particularly to a method of fabricating isolated device regions utilizing direct wafer bonding.

There are many problems associated with high speed integrated circuits and their fabrication. Junction isolated devices generally have high parasitic capacitance and leakages between the collector and substrate. Although dielectrically isolated monolithic microwave integrated circuits fabricated by forming monocrystalline material on a polycrystalline substrate generally have low parasitic capacitance and leakages between the collector and substrate, they are relatively expensive to fabricate and have the disadvantage of low density.

Another well known method of fabricating high speed IC's employs wafer bonding. Initially, a first monocrystalline silicon substrate is provided and a silicon dioxide layer is formed thereon. A second monocrystalline silicon substrate having a buried layer formed therein is bonded to the silicon dioxide layer so that the buried layer is actually bonded to the silicon dioxide. The second substrate is etched back to the buried layer following bonding. An epitaxial layer is formed on the etched back second wafer. Isolation trenches extending to the silicon dioxide are formed through the epitaxial layer and second substrate and are filled to isolate device regions therebetween. The etch back of the second wafer to the buried layer is extremely difficult to control and a tolerance of only ±0.5 microns can be attained. Because of this, it is extremely difficult to employ a very thin epitaxial layer with a fairly exact tolerance and the method is not VLSI compatible. Further, this type of structure is best suited for high current, high voltage applications.

In view of the above, it would be highly desirable to have a method of fabricating isolated device regions that are VLSI compatible and may be used in conjunction with high speed integrated circuits.

### Summary of the Invention

Accordingly, it is an object of the present invention to provide a method of fabricating isolated device regions that are VLSI compatible.

The foregoing and other objects and advantages are achieved in the present invention by one embodiment in which, as a part thereof, includes providing a first semiconductor substrate having a dielectric layer disposed thereon and bonding a second semiconductor substrate to the dielectric layer. A buried layer, for example of a single or multiple conductivity types, is implanted in the second substrate. An epitaxial layer is formed on the buried layer in the second substrate. Isolation trenches are then etched to the dielectric layer through the epitaxial layer and the second semiconductor substrate and are filled with dielectric material to isolate the regions therebetween.

It will be appreciated that an advantage of the present invention is that the depth of the buried layer can be controlled.

Preferably, the second substrate is etched back to a predetermined thickness prior to the formation of the buried layer.

Thus, it will be appreciated that the present invention provides a method of fabricating isolated device regions which can be employed in high speed, high frequency applications and which have reduced or eliminated leakage and reduced or eliminated junction capacitance.

A more complete understanding of the present invention can be attained by considering the following detailed description in conjunction with the accompanying drawings.

### Brief Description of the Drawings

FIG. 1 is a highly enlarged cross-sectional view of a partial semiconductor structure during processing in accordance with the present invention; and
FIG. 2 is a highly enlarged cross-sectional view of a partial semiconductor structure having isolated device regions in accordance with the present invention.

### Detailed Description of the Invention

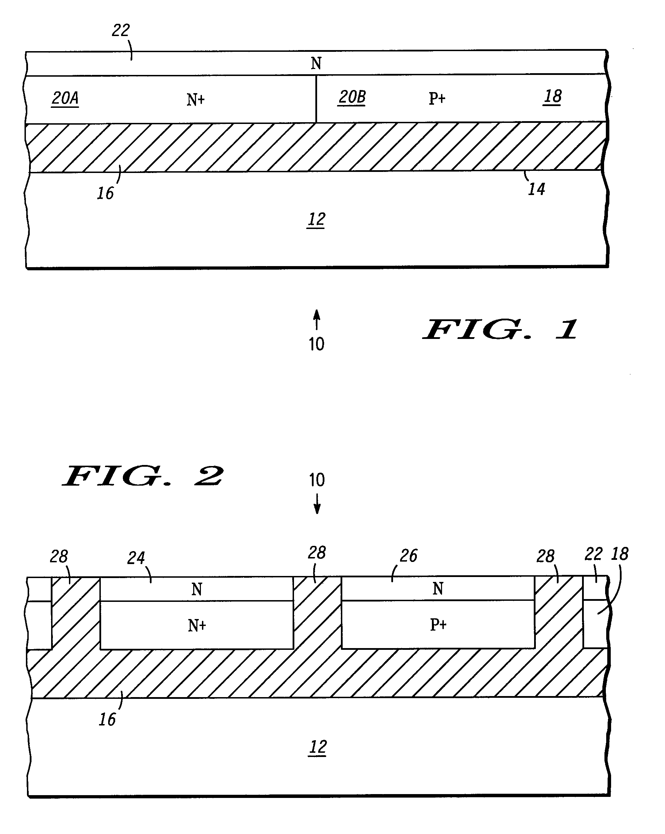

FIG. 1 is a highly enlarged cross-sectional view of a partial semiconductor structure 10 during processing. Structure 10 includes a first semiconductor substrate 12 having a first surface 14. In this embodiment, first semiconductor substrate 12 comprises monocrystalline silicon although it may comprise one of many other semiconductor materials well known in the art. Preferably, substrate 12 has a very high resistivity so that the coupling factor between isolated device regions 24 and 26 (see FIG. 2) will be minimized in finished structure 10. A dielectric layer 16 is formed on first surface 14 of first substrate 12. Dielectric layer 16 comprises silicon dioxide herein and has a thickness in the range of 0.1 to 5.0 microns. Preferably, dielectric layer 16 is approximately 2.0 microns thick. Dielectric layer 16 may be formed by one of many methods well known in the art.

Structure 10 further includes a second semiconductor substrate 18. Second substrate 18 also comprises monocrystalline silicon herein although other well known semiconductors may be employed. In this embodiment, second substrate 18 has a P conductivity type and a resistivity in the range of 1.0 to 1.5 ohm centimeters although the resistivity may be in the range of 0.1 to 15.0 ohm centimeters. Second substrate 18 is thermally bonded to dielectric layer 16. In this embodiment thermal bonding at a temperature in the range of 850 to 1200 degrees centigrade utilizing low pressures and a disolvable gas is employed. United States Patent 4,818,323 issued on April 4, 1989 to F. Secco d'Aragona and H. M. Liaw discloses a method of making a void free wafer bond via vacuum lamination and is incorporated herein by reference.

Once second substrate 18 has been bonded to dielectric layer 16, it is etched back to a thickness in the range of 1.0 to 5.0 microns. Specifically, a thickness of approximately 2.0 microns is preferred. The etching back or thinning of second substrate 18 may be done by one of many methods well known in the art. An etch back tolerance of ±0.05 microns may be obtained. Once second substrate 18 has been etched back, buried layers 20 are formed therein. Buried layers 20 comprise multiple conductivity types herein. In this embodiment, an N + buried layer 20A and a P + buried layer 20B having sheet resistances in the range of 10.0 to 500.0 ohms/square are formed in second substrate 18. Buried layers 20 are formed by standard methods that may include a masked implant or diffusion. It should be understood that buried layer 20 may also comprise only a single conductivity type.

Once buried layers 20 have been formed, an epitaxial layer 22 is formed on second substrate 18. Epitaxial layer 22 comprises silicon and has a thickness in the range of 0.5 to 5.0 microns and a preferred thickness of approximately 1.0 micron. In this embodiment, epitaxial layer 22 is of an N conductivity type and is relatively heavily doped having a resistivity in the range of 0.1 to 1.5 ohm centimeters and a preferred resistivity of approximately 0.4 ohm centimeters. Alternatively, epitaxial layer 22 may be of a P conductivity type.

FIG. 2 is a highly enlarged cross-sectional view of partial semiconductor structure 10 having isolated device regions 24 and 26. To form isolated device regions 24 and 26, isolation trenches 28 extending to dielectric layer 16 are etched through epitaxial layer 22 and second substrate 18. Isolation trenches 28 may be etched by one of many methods well known in the art although reactive ion etching is employed herein. Following the formation of isolation trenches 28, they are filled with dielectric material. Preferably, the dielectric material formed in isolation trenches 28 is the same as that which comprises dielectric layer 16, silicon dioxide in this embodiment. Following the filling of isolation trenches 28, partial semiconductor structure 10 is etched back so that it has a planar surface.

Once isolation trenches 28 have been filled and structure 10 planarized, active device fabrication may begin in isolated device regions 24 and 26. Dielectric layer 16 and filled isolation trenches 28 fully isolate device regions 24 and 26 and result in reduced or eliminated parasitic leakages and junction capacitances. Structure 10 is particularly well suited for high speed, high frequency RF integrated circuits. Further, structure 10 may also be employed for bipolar, complementary bipolar, CMOS and BICMOS integrated circuits.

Thus it is apparent that there has been provided, in accordance with the invention, an improved method of fabricating isolated device regions which meets the object and advantages set forth above. While specific embodiments of the present invention have been shown and described, further modifications and improvements will occur to those skilled in the art. It is desired that it be understood, therefore, that this invention is not limited to the particular forms shown and it is intended in the appended claims to cover all modifications which do not depart from the spirit and scope of this invention.

## Claims

1. A method of fabricating isolated device regions (24,26) comprising the steps of:
providing a first semiconductor substrate (12) having a dielectric layer (16) disposed on a first surface (14) thereof;
bonding a second semiconductor substrate (18) to said dielectric layer (16) disposed on said first substrate (12); the invention being characterized by:
forming a buried layer (20) in said second substrate (18);
forming an epitaxial layer (22) on said buried layer (20) in said second substrate (18);
forming isolation trenches (28) extending to said dielectric layer (16) through said epitaxial layer (22) and said second substrate (18); and
filling said isolation trenches (28) with dielectric material to isolate the regions (24,26) therebetween.

2. The method of claim 1 wherein the first (12) and second (18) semiconductor substrates comprise monocrystalline silicon and the dielectric layer (16) and dielectric material comprise an oxide.

3. The method of claim 1 wherein the second substrate (18) is etched back prior to the formation of the buried layer (20).

4. The method of claim 1 wherein the forming a buried layer (20) step includes forming a buried layer (20) of single or multiple conductivity types.

5. A method of fabricating isolated device regions (24,26) comprising the steps of:
providing a first silicon substrate (12) having a silicon oxide layer (16) disposed on a first surface (14) thereof;
bonding a second silicon substrate (18) to said silicon oxide layer (16);
etching back said second substrate (18) to a desired thickness; the invention being characterized by:
forming a buried layer (20) in said second substrate (18), said buried layer (20) comprising a single or multiple conductivity types;
forming a doped epitaxial silicon layer (22) on said second substrate (18);
etching isolation trenches (28) extending to said silicon oxide layer (16) through said epitaxial silicon layer (22) and said second substrate (18); and
filling said isolation trenches (28) with silicon oxide to isolate the regions (24,26) therebetween.

6. The method of claim 5 wherein the first (12) and second (18) silicon substrates comprise monocrystalline silicon.

7. The method of claim 6 wherein the silicon oxide layer (16) disposed on the first substrate (12) has a thickness in the range of 0.1 to 5.0 microns, the etching back step includes etching back the second substrate 18 to a thickness in the range of 1.0 to 5.0 microns and the forming an epitaxial layer 22 step includes forming an epitaxial layer 22 having a thickness in the range of 0.5 to 5.0 microns.

8. The method of claim 7 wherein the second substrate has a resistivity in the range of 0.1 to 15.0 ohm centimeters, the implanting a buried layer 20 step includes implanting a buried layer 20 having a sheet resistance in the range of 10.0 to 500.0 ohms square and the forming an epitaxial silicon layer 22 step includes forming an epitaxial silicon layer 22 having a resistivity in the range of 0.1 to 1.5 ohm centimeters.
